# EUROPÄISCHE PATENTANMELDUNG

(11) **EP 2 942 633 A1**
(43) Veröffentlichungstag der Anmeldung: **11.11.2015**
(21) Anmeldenummer: 14167158.6
(22) Anmeldetag: 06.05.2014
(51) Int. Cl.: G01R 31/34

(54) **Verfahren und Vorrichtung zum Detektieren von Windungsschlüssen sowie elektrische Maschine**

(71) Anmelder: Siemens Aktiengesellschaft, 80333 München (DE)
(72) Erfinder: Merte, Ralf, 44225 Dortmund (DE); Staubach, Christian, 45768 Marl (DE)

(57) **Zusammenfassung**

Die Erfindung betrifft ein Verfahren zum Detektieren von Windungsschlüssen innerhalb einer Läuferwicklung einer rotierenden elektrischen Maschine (2), bei welchem mittels der Radialkomponente der magnetischen Flussdichte B der rotierenden elektrischen Maschine (2) eine Spannungsinduktion innerhalb einer Messspule erzeugt wird, wobei mittels einer von der Radialkomponente abweichenden Richtungskomponente dieser magnetischen Flussdichte B innerhalb einer weiteren Messspule eine weitere Spannungsinduktion erzeugt wird, um in Abhängigkeit von zeitlichen Spannungsverläufen von in den zwei Messspulen induzierten Spannungen an der Läuferwicklung vorhandene Windungsschlüsse zu detektieren.

## Beschreibung

Die Erfindung betrifft ein Verfahren zum Detektieren von Windungsschlüssen innerhalb einer Läuferwicklung einer rotierenden elektrischen Maschine, bei welchem mittels der Radialkomponente der magnetischen Flussdichte B der rotierenden elektrischen Maschine eine Spannungsinduktion innerhalb einer Messspule erzeugt wird.

Die Erfindung betrifft eine Vorrichtung zum Detektieren von Windungsschlüssen innerhalb einer Läuferwicklung einer rotierenden elektrischen Maschine mit einer eine Messspule aufweisenden Messeinrichtung, bei welcher die Messspule derart in der Messeinrichtung angeordnet ist, dass bei einer entsprechend gegenüber der Läuferwicklung ausgerichteten Messeinrichtung mittels der Radialkomponente der magnetischen Flussdichte B der rotierenden elektrischen Maschine eine Spannungsinduktion innerhalb der Messspule erzeugbar ist.

Die Erfindung betrifft auch eine Vorrichtung zum Detektieren von Windungsschlüssen innerhalb einer Läuferwicklung einer rotierenden elektrischen Maschine mit einer Messeinrichtung.

Die Erfindung betrifft darüber hinaus auch eine elektrische Maschine, insbesondere einen Generator, mit einem Stator und einem darin umlaufenden Läufer.

Insbesondere gattungsgemäße Verfahren zum Detektieren von Windungsschlüssen speziell innerhalb von Läuferwicklungen sind im Zusammenhang mit großen, rotierenden elektrischen Maschinen, wie beispielsweise Generatoren, Turbogeneratoren oder dergleichen, aus dem Stand der Technik bekannt. Derartige Windungsschlüsse werden beispielsweise durch defekte Isolierungen an elektrischen Leitelementen in Läuferwicklungen verursacht, wodurch einzelne Windungen nicht mehr ordnungsgemäß zueinander isoliert sind. Insofern können Windungsschlüsse innerhalb von Läuferwicklungen großer, rotierender elektrischer Maschinen zur Folge haben, dass deren Betrieb dauerhaft negativ beeinträchtigt wird. Beispielsweise kann es zu einer thermischen Asymmetrie kommen, welche wiederum zu einem erhöhten Vibrationslevel des rotierenden Läufers oder zu Verzerrungen des Magnetfelds bis hin zu einem Totalausfall der gesamten rotierenden elektrischen Maschine führen kann. Allein schon aus diesen Gründen erscheint es zwingend erforderlich, derartige Windungsschlüsse innerhalb einer Läuferwicklung möglichst zeitnah zu detektieren, um potentiell größere Schäden an der rotierenden elektrischen Maschine zu vermeiden.

Aus dem Stand der Technik sind bereits mehrere Methoden bekannt, mittels welchen derartige Windungsschlüsse innerhalb von Läuferwicklungen rotierender elektrischer Maschinen detektiert werden können. Prinzipiell lassen sich diese Methoden in zwei unterschiedliche Verfahrensweisen unterscheiden, nämlich einerseits in eine erste Verfahrensweise, bei welcher eine Windungsschlussdetektion während des Betriebs einer rotierenden elektrischen Maschine, also online, und andererseits in eine weitere Verfahrensweise, bei welcher eine Windungsschlussdetektion während des Stillstands der rotierenden elektrischen Maschine, also offline, durchgeführt werden. Der größte Nachteil der offline-Verfahrensweise liegt wohl darin, dass aufgrund fehlender elektrischer, thermischer und vor allem mechanischer Belastungen etwaige Windungsschlüsse, welche sich erst im Betrieb der rotierenden elektrischen Maschine ergeben, während des Stillstandes der rotierenden elektrischen Maschine nicht oder nur derart schwach ausgeprägt vorliegen können, dass sie mittels einer entsprechenden Stillstandsdiagnose nicht betriebssicher detektierbar sind. Weiterhin kann eine derartige Stillstandsdiagnose aufgrund eines hiermit verbundenen erhöhten Arbeitsaufwands nur in zeitlich größeren Abständen, beispielsweise im Rahmen von Revisionen, wirtschaftlich durchgeführt werden. Insofern ist eine Windungsschlussprüfung einer Läuferwicklung bei dieser weiteren offline-Verfahrensweise nur unregelmäßig wirtschaftlich sinnvoll.

Gegensätzlich anders dazu verhält es sich hinsichtlich der ersten Verfahrensweise, welche online durchgeführt wird, also insofern auch permanent während des Betriebs angewendet werden kann. Bei der online-Verfahrensweise basiert das wohl diesbezüglich bekannteste Verfahren zur permanenten Windungsschlussprüfung und/oder -überwachung während des Betriebes auf eine elektrische Flussmessung mit einer Messspule (Flux Probe), welche derart in einem Luftspalt zwischen der Läuferumfangsfläche und einer hierzu komplementären Statorinnenfläche ausgerichtet angeordnet ist, dass durch das bewegte Läufermagnetfeld in der Messspule Spannungen induziert werden können.

Die Messspule ist hierbei derart in ein Statorgehäuse der rotierenden elektrischen Maschine gewickelt oder vergossen, dass deren aktive Fläche radial zur Läuferumfangsfläche ausgerichtet ist. Somit bewirkt lediglich die Radialkomponente der magnetischen Flussdichte B der rotierenden elektrischen Maschine eine Spannungsinduktion innerhalb der Messspule. Anhand einer Spannungsverlaufsanalyse der in der Messspule induzierten Spannung können Windungsschlüsse innerhalb der Läuferwicklung detektiert werden. Die Sensitivität bezüglich der Detektion der Windungsschlüsse anhand dieser Spannungsverlaufsanalyse hängt von einer Vielzahl von Faktoren ab. Maßgeblich sind hier die Charakteristik des jeweiligen Windungsschlusses einerseits sowie die Position des Windungsschlusses innerhalb der Läuferwicklung andererseits. Weiterhin beeinflusst die Fahrweise der rotierenden elektrischen Maschine, die abgegebene Wirkleistung, der Verlustfaktor cosϕ, die Empfindlichkeit dieser Messmethode. Insofern wird empfohlen, verschiedene Lastpunkte im Betrieb der rotierenden elektrischen Maschine anzufahren, um eine möglichst präzise Detektion von Windungsschlüssen zu erzielen. Dies ist jedoch sehr umständlich. Zudem können die in der Messspule gemessenen Spannungsverläufe durch eine vorherrschende Läuferexzentrizität verfälscht werden, wodurch es möglicherweise zu einer Fehlinterpretation kommen kann.

Es ist Aufgabe der Erfindung, gattungsgemäße Verfahren zum Detektieren von Windungsschlüssen innerhalb von Läuferwicklungen rotierender elektrischer Maschinen weiterzuentwickeln, so dass eine zuverlässigere Detektierung derartiger Windungsschlüsse gewährleistet ist.

Die Aufgabe der Erfindung wird von einem Verfahren zum Detektieren von Windungsschlüssen innerhalb einer Läuferwicklung einer rotierenden elektrischen Maschine gelöst, bei welchem mittels der Radialkomponente der magnetischen Flussdichte B der rotierenden elektrischen Maschine eine Spannungsinduktion innerhalb einer Messspule erzeugt wird, wobei mittels einer von der Radialkomponente abweichenden Richtungskomponente dieser magnetischen Flussdichte B innerhalb einer weiteren Messspule eine weitere Spannungsinduktion erzeugt wird, um in Abhängigkeit von zeitlichen Spannungsverläufen von in den Messspulen induzierten Spannungen an der Läuferwicklung vorhandene Windungsschlüsse zu detektieren.

Erfindungsgemäß werden zum Detektieren von Windungsschlüssen innerhalb der Läuferwicklung der elektrischen Maschine nicht nur Ereignisse einer Spannungsinduktion einer einzigen Messspule herangezogen, wie dies bisher üblich ist. Vielmehr wird diese bekannte Verfahrensweise dadurch präzisiert, dass zur Bewertung eines Vorliegens eines Windungsschlusses der Spannungsverlauf innerhalb einer zweiten Messspule zusätzlich analysiert wird. Und zwar in Bezug auf eine andere Richtungskomponenten des von der elektrischen Maschine erzeugten magnetischen Flussdichte B.

Die Aufgabe der Erfindung wird von einer Vorrichtung zum Detektieren von Windungsschlüssen innerhalb einer Läuferwicklung einer rotierenden elektrischen Maschine mit einer eine Messspule aufweisenden Messeinrichtung gelöst, bei welcher die Messspule derart in der Messeinrichtung angeordnet ist, dass bei einer entsprechend gegenüber der Läuferwicklung ausgerichteten Messeinrichtung mittels der Radialkomponente der magnetischen Flussdichte B der rotierenden elektrischen Maschine eine Spannungsinduktion innerhalb der Messspule erzeugbar ist, wobei die Messeinrichtung mindestens eine weitere Messspule umfasst, welche derart gegenüber der ersten Messspule angeordnet ist, dass mittels einer von der Radialkomponente abweichenden Richtungskomponente dieser magnetischen Flussdichte B eine andere Spannungsinduktion innerhalb der weiteren Messspule erzeugbar ist, so dass in Abhängigkeit von zeitlichen Spannungsverläufen von in den zwei Messspulen induzierten Spannungen an der Läuferwicklung vorhandene Windungsschlüsse detektierbar sind.

Erfindungsgemäß wird zur Detektierung von Windungsschlüssen neben einer Wirkung der Radialkomponente der durch die elektrische Maschine erzeugten magnetischen Flussdichte B noch eine weitere Wirkung mindestens einer anderen Richtungskomponente dieser magnetischen Flussdichte B auf zwei unterschiedlich im Raum ausgerichtete Messspulen ausgewertet. Hierdurch stehen zur Beurteilung von Windungsschlüssen mindestens zwei unterschiedliche zeitliche Spannungsverläufe zweier unterschiedlich gegenüber der Läuferumfangsfläche bzw. Läuferoberfläche ausgerichteter Messspulen zur Verfügung, wodurch die Detektiergenauigkeit signifikant gesteigert ist. Somit kann die Gefahr von bisher möglichen Fehlinterpretationen erheblich reduziert werden.

Insbesondere mit dieser Vorrichtung kann das erfindungsgemäße Verfahren unmittelbar durchgeführt werden.

Die Aufgabe der Erfindung wird darüber hinaus allgemeiner auch von einer Vorrichtung zum Detektieren von Windungsschlüssen innerhalb einer Läuferwicklung einer rotierenden elektrischen Maschine mit einer Messeinrichtung gelöst, wobei die Messeinrichtung mindestens zwei derart unterschiedlich im Raum orientierte Messspulen umfasst, dass bei einer entsprechend gegenüber der Läuferwicklung ausgerichteten Messeinrichtung mittels einer ersten Richtungskomponente der magnetischen Flussdichte B der rotierenden elektrischen Maschine eine Spannungsinduktion innerhalb der ersten Messspule und dass mittels einer von der ersten Richtungskomponente verschiedene weiteren Richtungskomponente dieser magnetischen Flussdichte B eine andere Spannungsinduktion innerhalb der weiteren Messspule erzeugbar sind, so dass in Abhängigkeit von zeitlichen Spannungsverläufen der in den zwei Messspulen induzierten Spannungen an der Läuferwicklung vorhandene Windungsschlüsse detektierbar sind.

Erfindungsgemäß werden zur Detektierung zwei unterschiedliche zeitliche Spannungsverläufe zweier unterschiedlich gegenüber der Läuferumfangsfläche bzw. Läuferoberfläche ausgerichtete Messspulen analysiert, wodurch die Detektiergenauigkeit signifikant gesteigert ist. Bei geeigneter Ausgestaltung der Vorrichtung muss keine der in den Messspulen erzeugten Spannungsinduktionen auf Basis der Radialkomponente der durch die elektrische Maschine erzeugten magnetischen Flussdichte B basieren. Jedenfalls kann auch mit dieser letztgenannten Vorrichtung die Gefahr möglicher Fehlinterpretationen erheblich reduziert werden. Darüber hinaus kann auf ein Anfahren unterschiedlicher Lastpunkte der elektrischen Maschine explizit verzichtet werden.

Vorteilhafterweise ist jedoch mittels der Radialkomponente dieser magnetischen Flussdichte B eine Spannungsinduktion innerhalb der ersten Messspule erzeugbar, so dass auf Erfahrungen bisheriger Analyseerfahrungen zurückgegriffen werden kann.

Eine bevorzugte Verfahrensvariante sieht vor, dass mittels der Axialkomponente dieser magnetischen Flussdichte B eine andere Spannungsinduktion innerhalb der weiteren Messspule erzeugt wird. Hierdurch kann eine definierte Erhöhung der Sensitivität bezüglich einer Windungsschlusserkennung erreicht werden.

Insbesondere, wenn die weitere Messspule derart gegenüber der ersten Messspule angeordnet ist, dass mittels der Axialkomponente dieser magnetischen Flussdichte B eine andere Spannungsinduktion innerhalb der weiteren Messspule erzeugbar ist, kann eine höhere Empfindlichkeit für eine etwaige Windungsschlusserkennung erzielt werden.

Eine weitere Verbesserung des vorliegenden Verfahrens kann erzielt werden, wenn mittels der Tangentialkomponente dieser magnetischen Flussdichte B eine zusätzliche Spannungsinduktion innerhalb einer dritten Messspule erzeugt wird.

Diese zusätzliche Spannungsinduktion kann konstruktiv sehr einfach bereit gestellt werden, wenn die Messeinrichtung eine dritte Messspule umfasst, welche derart gegenüber der ersten Messspule angeordnet ist, dass mittels der Tangentialkomponente dieser magnetischen Flussdichte B eine Spannungsinduktion innerhalb einer dritten Messspule erzeugbar ist.

Insgesamt können Fehlinterpretationen bezüglich Windungsschlüssen, welche beispielweise auch auf eine Läuferexzentrizität zurück zu führen sind, erheblich reduziert werden, wenn eine zusätzliche Analyse von zwei zusätzlichen Raumrichtungskomponenten bezüglich der durch die elektrische Maschine erzeugten magnetischen Flussdichte B erfolgen kann.

Eine sehr zuverlässige Messgenauigkeit kann erzielt werden, wenn die Messspulen an der Messeinrichtung derart unterschiedlich orientiert angeordnet sind, dass ihre Flächenvektoren orthogonal zueinander angeordnet sind. Hierdurch können die in den drei Messspulen induzierten Spannungsverläufe bezüglich der magnetischen Flussdichtekomponenten in Radial-, Axial- oder Tangentialrichtung zuverlässig erzeugt und für weitere Analysezwecke bereitgestellt werden.

Die Vorrichtung kann konstruktiv einfach ausgestaltet sein, wenn die Messspulen an einem kubischen Würfelelement der Messeinrichtung angeordnet sind.

Vorteilhafterweise umfasst die Vorrichtung noch eine Analyseeinrichtung, mittels welcher die durch die Radial-, die Axial- und/oder die Tangentialkomponenten erzeugten Spannungsinduktionen gemeinsam analysiert werden können.

Die Aufgabe der Erfindung wird auch von einer elektrischen Maschine, insbesondere von einem Generator, mit einem Stator und einem darin umlaufenden Läufer gelöst, wobei sich die elektrische Maschine durch eine der hier beschriebenen Vorrichtungen auszeichnet.

Mit der vorliegenden Erfindung und insbesondere mittels der erfindungsgemäßen elektrischen Maschine ist somit eine sensitive Windungsschlussdetektion, -prüfung und/oder online-Überwachung an Rotoren mittels raumrichtungsabhängiger Flux-Messung möglich.

Die erzielbaren Vorteile dieser raumrichtungsabhängigen Flux-Messung wurden bereits mittels theoretischer Berechnungsmodelle auf Basis der Finite-Elemente-Methode detailliert analysiert. Hierbei zeigte sich, dass abhängig von der Position des Windungsschlusses innerhalb der Läuferwicklung und dem betriebenen Lastpunkt der elektrischen Maschine, die Auswertung insbesondere der Radial- oder Tangentialkomponente eine höhere Empfindlichkeit für eine etwaige Windungsschlusserkennung aufweist. Durch die Verwendung der raumrichtungsabhängigen Flux-Messung werden alle Komponenten der magnetischen Flussdichte implizit erfasst und ein Monitoring der vektoriellen Größe der magnetischen Feldstärke ist möglich.

Weitere Merkmale, Effekte und Vorteile vorliegender Erfindung werden anhand anliegender Zeichnung und nachfolgender Beschreibung erläutert, in welchen beispielhaft eine erfindungsgemäße Vorrichtung zum Detektieren von Windungsschlüssen innerhalb einer Läuferwicklung dargestellt und beschrieben ist.

In der Zeichnung zeigen:
- Figur 1: schematisch eine Teilansicht einer an einem Stators einer elektrischen Maschine montierten Messeinrichtung der vorliegenden Vorrichtung;
- Figur 2: schematisch eine perspektivische Ansicht der Messeinrichtung aus der Figur 1;
- Figur 3: schematisch eine Ansicht eines Diagramms bezüglich berechneter Spannungsverläufe hervorgerufen durch eine Radial- und Tangentialkomponente der magnetischen Flussdichte B der elektrischen Maschine aus der Figur 1; und
- Figur 4: schematisch eine Ansicht eines weiteren Diagramms bezüglich gemessener Spannungsverläufe hervorgerufen durch eine Radial-, Axial-, und Tangentialkomponente der magnetischen Flussdichte B der elektrischen Maschine aus der Figur 1.

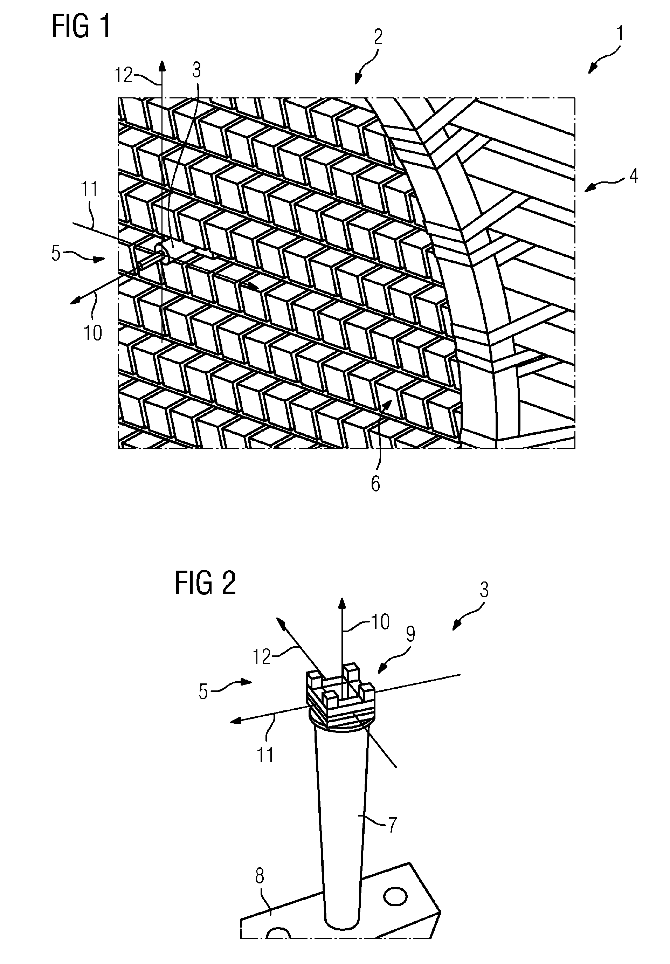

Die vorliegende Vorrichtung 1 zum Detektieren von Windungsschlüssen (nicht gezeigt) innerhalb einer Läuferwicklung (nicht gezeigt) einer in der Figur 1 nur teilweise gezeigten rotierenden elektrischen Maschine 2 ist exemplarisch nur hinsichtlich ihrer Messeinrichtung 3 (siehe auch Figur 2) gezeigt. Die Messeinrichtung 3 ist hierbei in einem Stator 4 der elektrischen Maschine 2 derart integriert, dass die Messeinrichtung 3 zumindest mit ihrem Kopfteil 5 über eine Innenfläche 6 des Stators 4 in einen Luftspalt (nicht gezeigt) zwischen der Innenfläche 6 des Stators 4 und einer nicht gezeigten Läuferumfangsfläche hinein ragt.

Wie gemäß der Darstellung nach der Figur 2 erkennbar ist, ist das Kopfteil 5 mittels eines Stangenelements 7 von einem Montagefußelement 8 der Messeinrichtung 3 beabstandet angeordnet, so dass bei ordnungsgemäßer Montage der Messeinrichtung 3 an dem Stators 4 gewährleistet ist, dass das Kopfteil 5 innerhalb des Luftspalts platziert ist.

Das Kopfteil 5 umfasst in diesem Ausführungsbeispiel ein kubisches Würfelelement 9, an welchem drei Messsensoren (nicht sichtbar) derart gewickelt sind, dass deren jeweiliger Flächenvektor 10, 11 bzw. 12 orthogonal zueinander ausgerichtet an der Messeinrichtung 3 angeordnet sind.

Hierbei sind die Flächenvektoren 10, 11 und 12 dementsprechend derart gegenüber der Läuferumfangsfläche ausgerichtet angeordnet, dass in jeweils einer der Messspulen eine Spannungsinduktion entweder von der Radialkomponente, der Axialkomponente oder der Tangentialkomponente der durch die elektrischen Maschine 2 erzeugten magnetischen Flussdichte B bewirkt wird.

Somit kann mittels der Vorrichtung 1 eine dreiachsige Vermessung der magnetischen Flussdichte B der elektrischen Maschine vorgenommen werden und für eine anschließende Analyse bezüglich des Detektierens von Windungsschlüssen genutzt werden.

Die Auswertung der aufgenommenen bzw. ermittelten Spannungsverläufe kann hierbei mit kommerziell erhältlicher Messtechnik erfolgen, jedoch werden hierzu drei Kanäle benötigt.

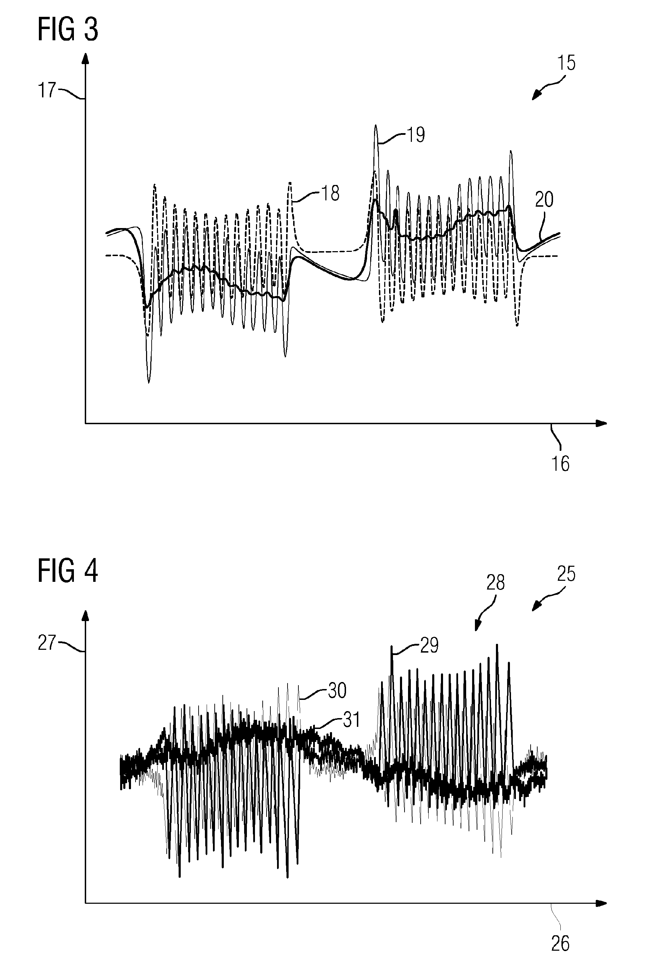

Gemäß der Darstellung nach der Figur 3 ist ein Diagramm 15 gezeigt, an dessen Abszisse 16 der zeitliche Verlauf und an dessen Ordinate 17 die Spannungsinduktionen abgetragen sind, welche von der magnetischen Flussdichte B an den entsprechenden Messspulen der Messvorrichtung 3 der Vorrichtung 1 verursacht sind. Hierbei erkennt man einerseits den berechneten Spannungsverlauf 18 hervorgerufen durch die Tangentialkomponente der magnetischen Flussdichte B und andererseits den berechneten Spannungsverlauf 19 hervorgerufen durch die Radialkomponente der magnetischen Flussdichte B. Darüber hinaus ist noch der Spannungsverlauf 20 einer Radialkomponente (Zahn) abgebildet.

Gemäß des weiteren mit der Darstellung nach der Figur 4 gezeigten Diagramms 25 sind an der diesbezüglichen Abszisse 26 der zeitliche Verlauf und an dessen Ordinate 27 die Spannungsinduktionen abgetragen. An diesem weiteren Diagramm 25 sind die Spannungsverläufe 28, nämlich der radialen Spannungsinduktion 29, der tangentialen Spannungsinduktion 30 und der axialen Spannungsinduktion 31, der mithilfe der Messspulen der Messeinrichtung 3 ermittelten verschiedenen Messspannungen aller drei Raumrichtungen dargestellt.

Obwohl die Erfindung im Detail durch das bevorzugte Ausführungsbeispiel näher illustriert und beschrieben wurde, so ist die Erfindung nicht durch dieses offenbarte Ausführungsbeispiel eingeschränkt, und andere Variationen können vom Fachmann hieraus abgeleitet werden, ohne den Schutzumfang der Erfindung zu verlassen.

## Patentansprüche

1. Verfahren zum Detektieren von Windungsschlüssen innerhalb einer Läuferwicklung einer rotierenden elektrischen Maschine (2),
bei welchem mittels der Radialkomponente der magnetischen Flussdichte B der rotierenden elektrischen Maschine (2) eine Spannungsinduktion innerhalb einer Messspule erzeugt wird,
wobei mittels einer von der Radialkomponente abweichenden Richtungskomponente dieser magnetischen Flussdichte B innerhalb einer weiteren Messspule eine weitere Spannungsinduktion erzeugt wird, um in Abhängigkeit von zeitlichen Spannungsverläufen von in den Messspulen induzierten Spannungen an der Läuferwicklung vorhandene Windungsschlüsse zu detektieren.

2. Verfahren nach Anspruch 1,
wobei mittels der Axialkomponente dieser magnetischen Flussdichte B eine andere Spannungsinduktion innerhalb der weiteren Messspule erzeugt wird.

3. Verfahren nach Anspruch 1 oder 2,
wobei mittels der Tangentialkomponente dieser magnetischen Flussdichte B eine zusätzliche Spannungsinduktion innerhalb einer dritten Messspule erzeugt wird.

4. Vorrichtung (1) zum Detektieren von Windungsschlüssen innerhalb einer Läuferwicklung einer rotierenden elektrischen Maschine (2) mit einer eine Messspule aufweisenden Messeinrichtung (3),
bei welcher die Messspule derart in der Messeinrichtung (3) angeordnet ist, dass bei einer entsprechend gegenüber der Läuferwicklung ausgerichteten Messeinrichtung (3) mittels der Radialkomponente der magnetischen Flussdichte B der rotierenden elektrischen Maschine (2) eine Spannungsinduktion innerhalb der Messspule erzeugbar ist,
insbesondere zum Durchführen des Verfahrens nach einem der Ansprüche 1 bis 3,
wobei die Messeinrichtung (3) mindestens eine weitere Messspule umfasst, welche derart gegenüber der ersten Messspule angeordnet ist, dass mittels einer von der Radialkomponente abweichenden Richtungskomponente dieser magnetischen Flussdichte B eine andere Spannungsinduktion innerhalb der weiteren Messspule erzeugbar ist, so dass in Abhängigkeit von zeitlichen Spannungsverläufen von in den zwei Messspulen induzierten Spannungen an der Läuferwicklung vorhandene Windungsschlüsse detektierbar sind.

5. Vorrichtung (1) zum Detektieren von Windungsschlüssen innerhalb einer Läuferwicklung einer rotierenden elektrischen Maschine (2) mit einer Messeinrichtung (3),
wobei die Messeinrichtung (3) mindestens zwei derart unterschiedlich im Raum orientierte Messspulen umfasst, dass bei einer entsprechend gegenüber der Läuferwicklung ausgerichteten Messeinrichtung (3) mittels einer ersten Richtungskomponente der magnetischen Flussdichte B der rotierenden elektrischen Maschine (2) eine Spannungsinduktion innerhalb der ersten Messspule und dass mittels einer von der ersten Richtungskomponente verschiedene weiteren Richtungskomponente dieser magnetischen Flussdichte B eine andere Spannungsinduktion innerhalb der weiteren Messspule erzeugbar sind,
so dass in Abhängigkeit von zeitlichen Spannungsverläufen der in den zwei Messspulen induzierten Spannungen an der Läuferwicklung vorhandene Windungsschlüsse detektierbar sind.

6. Vorrichtung (1) nach Anspruch 5,
wobei mittels der Radialkomponente dieser magnetischen Flussdichte B eine Spannungsinduktion innerhalb der ersten Messspule erzeugbar ist.

7. Vorrichtung (1) nach einem der Ansprüche 4 bis 6,
wobei die weitere Messspule derart gegenüber der ersten Messspule angeordnet ist, dass mittels der Axialkomponente dieser magnetischen Flussdichte B eine andere Spannungsinduktion innerhalb der weiteren Messspule erzeugbar ist.

8. Vorrichtung (1) nach einem der Ansprüche 4 bis 7,
wobei die Messeinrichtung (3) eine dritte Messspule umfasst,
welche derart gegenüber der ersten Messspule angeordnet ist, dass mittels der Tangentialkomponente dieser magnetischen Flussdichte B eine zusätzliche Spannungsinduktion innerhalb der dritten Messspule erzeugbar ist.

9. Vorrichtung (1) nach einem der Ansprüche 4 bis 8,
wobei die Messspulen an der Messeinrichtung (3) derart unterschiedlich orientiert angeordnet sind, dass ihre Flächenvektoren (10, 11, 12) orthogonal zueinander angeordnet sind.

10. Vorrichtung (1) nach einem der Ansprüche 4 bis 9,
wobei die Messspulen an einem kubischen Würfelelement der Messeinrichtung (3) angeordnet sind.

11. Elektrische Maschine (2),
insbesondere Generator,
mit einem Stator (4) und einem darin umlaufenden Läufer, wobei sich die elektrische Maschine (2) durch eine Vorrichtung (1) nach einem der Ansprüche 4 bis 10 auszeichnet.
